# EUROPEAN PATENT SPECIFICATION

(11) **EP 2 956 958 B1**
(45) Date of publication and mention of the grant of the patent: **16.10.2019**
(21) Application number: 13874969.2
(22) Date of filing: 17.09.2013
(51) Int. Cl.: C23C 16/44, B01D 53/76

(54) **INLET AND REACTING SYSTEM HAVING THE SAME**
EINLASS UND REAKTIONSSYSTEM DAMIT
ENTRÉE ET SYSTÈME À RÉACTION ÉQUIPÉ DE CELLE-CI

(30) Priority: 14.02.2013 KR 20130015739
(43) Date of publication of application: 23.12.2015
(73) Proprietor: LG Siltron Incorporated, Gumi-si, Gyeongsangbuk-do 730-724 (KR)
(72) Inventor: CHO, Man Kee, Daegu 706-793 (KR); SON, Su Bin, Gumi-si Gyeongsangbuk-do 730-300 (KR); RYU, Deuk Cheon, Chilgok-gun Gyeongsangbuk-do 718-845 (KR)
(74) Representative: Beder, Jens
(86) International application number: PCT/KR2013/008395
(87) International publication number: WO 2014/126318

(56) References cited:
- WO-A1-98/29178
- GB-A- 1 501 807
- JP-A- 2002 316 015
- JP-A- 2006 116 470
- KR-A- 20070 016 241
- KR-A- 20080 058 094
- KR-A- 20090 081 983
- KR-Y1- 200 366 263
- US-A1- 2004 185 661

## Description

### Technical Field

The present invention relates to an inlet of a scrubber for gas processing in a semiconductor manufacturing process and a reacting system having the same.

### Background Art

Various kinds of reaction gases used in a semiconductor process of forming a thin film on a wafer contain oxidative components, flammable components, and harmful components. Accordingly, if a waste gas, an exhaust reaction gas, is directly emitted into the atmosphere, it may harm human bodies and pollute the environment.

A scrubber to remove harmful components from the waste gas may be installed in an exhaust line of semiconductor equipment for exhaust of waste gas. To emit the waste gas into the atmosphere through a purification process of lowering the harmful component content of the waste gas to a concentration equal to or lower than an allowable concentration, a scrubber is used, which may be one of various types of scrubbers including a burn scrubber, a burn and wet scrubber, a burn and dry scrubber, a dry scrubber, and a wet scrubber.

An inlet is needed to connect the exhaust line of the semiconductor equipment with the scrubber. The waste gas introduced into the exhaust line and a cleaning solution to eliminate contaminants contained in the waste gas may be together introduced into the scrubber. At this time, a reaction product may be produced by reaction between the cleaning solution and contaminants. Accordingly, the inlet may be clogged by the produced reaction product.

Patent document JP 2002 316015 A discloses a waste gas inlet for a scrubber.

### Disclosure of Invention

### Technical Problem

An object of the present invention devised to solve the problem lies on an inlet that may extend the replacement period and reduce time for which a reacting system is stopped, contributing to increase in the amount of production, and a reacting system having the same.

### Solution to Problem

The object of the present invention can be achieved by providing an inlet according to claim 1 including a body provided therein with a transport duct allowing a fluid to flow therethrough, at least one first nozzle connected to one region of a lateral surface of the body and adapted to spray a cleaning solution into the transport duct, and a blocking sheet disposed in the transport duct to be spaced apart from an inner wall of the transport duct, wherein the cleaning solution sprayed from the first nozzle is blocked from being introduced into one region of the transport duct positioned inside the blocking sheet.

An upper end of the blocking sheet is positioned at an upper side of the first nozzle, and a lower end of the blocking sheet is positioned at a lower side of the first nozzle.

The body may be provided with a fixing portion positioned at an upper side of the first nozzle in the transport duct to support an upper end of the blocking sheet.

The fixing portion may be a part of the body positioned at the upper side of the first nozzle, wherein an inner diameter of the fixing portion may be less than an inner diameter of the other part of the body.

At least one first nozzle may include a plurality of first nozzles arranged spaced apart from each other.

An angle formed between the first nozzles and an outer wall of the body positioned at an upper side of the first nozzles may be between 50° and 70°.

The blocking sheet may be formed of a resin material having a coefficient of friction less than a coefficient of friction of the body. The blocking sheet may be formed of polytetrafluoroethylene.

The blocking sheet may be provided with an upper end, a lower end, and a lateral surface positioned between the upper end and the lower end, and may be formed in a cylindrical shape and open at the upper end of the lower end.

The upper end of the blocking sheet may be formed in a ring shape having a diameter greater than a diameter of the lateral surface to be held by the fixing portion. The upper end of the blocking sheet may protrude from the lateral surface.

The inlet further includes at least one second nozzle connected to another region of the lateral surface of the body positioned under the blocking sheet and adapted to spray an inert gas into the transport duct. The at least one second nozzle may include a plurality of second nozzles arranged spaced apart from each other.

The angle formed between the second nozzles and an outer wall of the body positioned at an upper side of the second nozzles may be between 50° and 70°.

The second nozzles may spray the inert gas along an inner wall of the transport duct.

An angle formed between a direction in which the second nozzle sprays the inert gas and a normal line to an inner wall of the transport duct may be greater than 0°and less than 10°.

The inlet may further include at least one spray nozzle to spray, at a predetermined spray pressure, a gas or a liquid onto a reaction product deposited on a lower end of the blocking sheet or deposited on an inner wall of ht transport duct under the blocking sheet, wherein the reaction product may be an output according to reaction between the fluid introduced into the transport duct and the cleaning solution.

The least one first nozzle and the at least one spray nozzle may spray deionized water, the at least one spray nozzle including a plurality of spray nozzles.

A ratio of a spray pressure of the deionized water sprayed from the first nozzle to a spray pressure of the deionized water sprayed from the spray nozzle may be 1 : 1.5 to 3.

In another aspect of the present invention, provided herein is a reacting system according to claim 20 including a gas introduction pipe to supply a source gas, a reactor to form a reaction product using the source gas supplied through the gas introduction pipe, a gas discharge pipe to discharge a gas produced after formation of the reaction product from the reactor, a scrubber to clean the gas discharged from the gas discharge pipe using a cleaning solution, and an inlet to connect the gas discharge pipe to the scrubber, wherein the inlet includes a body provided therein with a transport duct allowing a fluid to flow therethrough, at least one first nozzle connected to one region of a lateral surface of the body and adapted to spray the cleaning solution into the transport duct, and a blocking sheet disposed in the transport duct to be spaced apart from an inner wall of the transport duct, wherein the cleaning solution sprayed from the first nozzle is blocked from being introduced into one region of the transport duct positioned inside the blocking sheet.

### Advantageous Effects of Invention

According to one embodiment, a replacement period may be extended, and the time for which the reacting system is stopped for replacement of the inlet may be reduced. Thereby, the amount of production may increase.

### Brief Description of Drawings

The accompanying drawings, which are included to provide a further understanding of the invention, illustrate embodiments of the invention and together with the description serve to explain the principle of the invention.

In the drawings:
FIG. 1 illustrates a reacting system including a scrubber equipped with an inlet according to an exemplary embodiment and a reactor;
FIG. 2 is a front view showing an inlet according to a first embodiment;
FIG. 3 is a cross-sectional view illustrating the inlet shown in FIG. 2;
FIG. 4 illustrates a blocking sheet shown in FIG. 3;
FIG. 5 is a conceptual view illustrating the function of the blocking sheet shown in FIG. 3;
FIG. 6A illustrates formation of a reaction product in the cast that the blocking sheet is not provided;
FIG. 6B illustrates formation of a reaction product in the cast that the blocking sheet is provided.
FIG. 7 is a front view illustrating an inlet according to a second embodiment;
FIG. 8 is a cross-sectional view illustrating the inlet shown in FIG. 7;
FIG. 9 is a conceptual view illustrating the function of a second nozzle shown in FIG. 8;
FIG. 10 is a view illustrating the spray direction of the second nozzle shown in FIG. 8;
FIGs. 11A and 11B illustrate a spray direction of the second nozzles according to one embodiment;
FIG. 12 is a front view illustrating an inlet according to a third embodiment;
FIG. 13 is a cross-sectional view illustrating the inlet shown in FIG. 12;
FIG. 14 illustrates disposition of spray nozzles of the inlet shown in FIG. 12; and
FIG. 15 is a conceptual view illustrating the function of the spray nozzles shown in FIG. 13.

### Best Mode for Carrying out the Invention

Reference will now be made in detail to the preferred embodiments of the present invention, examples of which are illustrated in the accompanying drawings. In the disclosure of embodiments, when a layer (film), a region, a pattern, or a structure is described as being formed "on" or "under" a substrate, a layer (a film), a region, a pad, or a pattern, the terms "on" and "under" connote not only "directly on" and "directly under" but also "indirectly on" and "directly under" with an interposed layer. In addition, the concepts of "on" and "under" are defined with reference to the drawings.

Regarding the sizes of constituents shown in the drawings, the constituents are exaggerated, omitted, or schematically shown for clear and easy description. In addition, the size of each constituent does not fully reflect the real size. Wherever possible, the same reference numbers will be used throughout the drawings to refer to the same or like parts. Hereinafter, a scrubber and an inlet according to embodiments will be described with reference to the accompanying drawings.

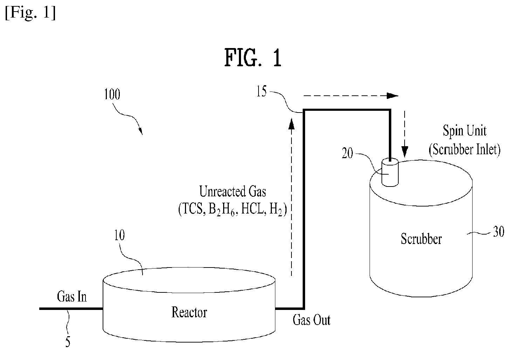

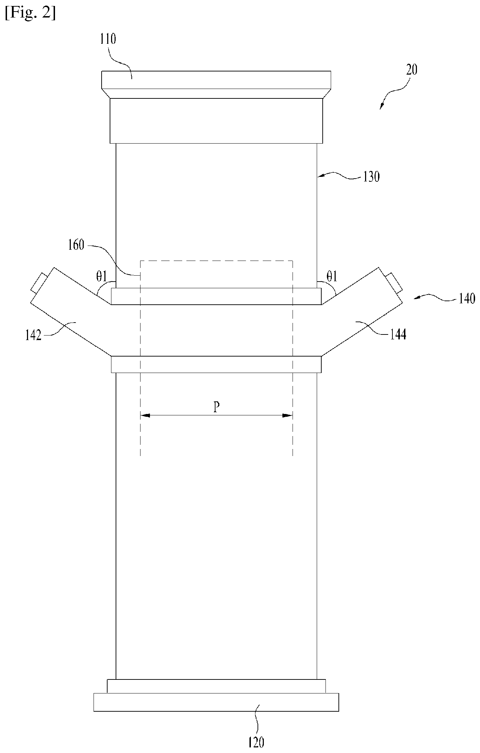

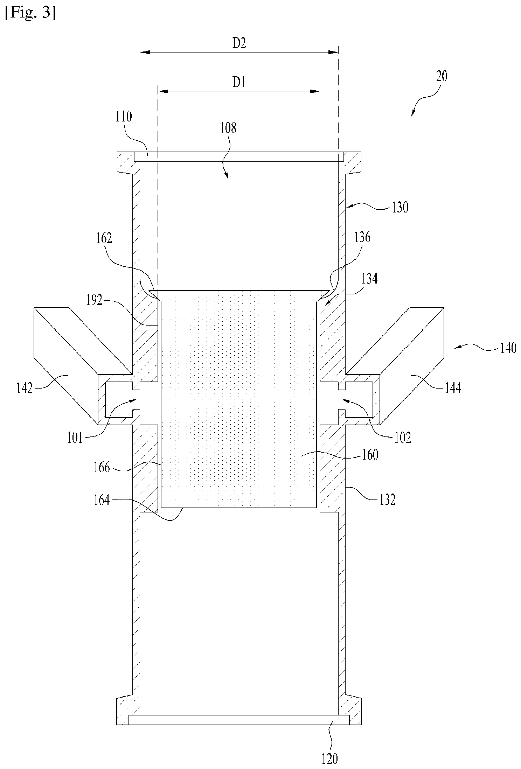

FIG. 1 illustrates a reacting system 100 including a scrubber 30 equipped with an inlet 20 according to an exemplary embodiment and a reactor 10, and FIG. 2 is a front view showing the inlet 20 according to a first embodiment. FIG. 3 is a cross-sectional view illustrating the inlet 20 shown in FIG. 2. The reacting system 100 may be an epitaxial reacting apparatus. However, embodiments are not limited thereto.

Referring to FIGs. 1 to 3, the reacting system 100 may include a gas introduction pipe 5, a reactor 10, a gas discharge pipe 15, an inlet 20, and a scrubber 30.

The gas introduction pipe 5 is connected to the reactor 10 to provide various source gases to the reactor 10.

The reactor 10 may perform a specific reaction using a source gas supplied through the gas introduction pipe 5, and may form a reaction product as a result of the reaction. For example, the reactor 10 may form a thin film on a wafer through an epitaxial reaction.

The gas discharge pipe 15 may be connected to the reactor 10. A gas produced after formation of a reaction product may be discharged from the reactor 10 through the gas discharge pipe 15. Herein, the gasses discharged through the gas discharge pipe 15 may be unreacted gases (e.g., TCS, B2H6, HCL and H2) and contaminants.

The inlet 20 may connect the gas discharge pipe 15 to the scrubber 30, functioning as a passage through which unreacted gases and contaminants discharged through the gas discharge pipe 15 move to the scrubber 30.

When the inlet 20 is clogged by the reaction product, unreacted gases and contaminants cannot move to the scrubber 30. In this case, the inlet 30 needs to be removed to eliminate the reaction product or to be replaced with a new one.

The scrubber 30 is capable of cleaning the unreacted gases and gaseous contaminants discharged from the gas discharge pipe 15 using a cleaning solution.

The contaminants introduced into the scrubber 30 may closely contact the cleaning solution stored in the scrubber 30 to dissolve in the cleaning solution, or to react with a reagent diffused through the cleaning solution to be neutralized.

The inlet 20 includes an introduction portion 110, a discharge portion 120, a body 130, a first nozzle 140, and a blocking sheet 160.

The introduction portion 110 may be connected to one end of the body 130 and provided with a hollow inner space to allow a fluid to be introduced thereinto.

The discharge portion 120 may be connected to the other end of the body 130 and provided with a hollow inner space to allow a fluid to be discharged therethrough. For example, the introduction portion 110, the body 130 and the discharge portion 120 may be integrated with each other. However, embodiments are not limited thereto.

The body 130 may include a transport duct 108 allowing a fluid to pass therethrough.

For example, the body 130 may include a transport duct 108 formed in the shape of a hollow cylindrical pipe allowing a fluid to pass therethrough.

The body 130 may be formed of a plastic material, for example, polyvinyl chloride (PVC). However, embodiments are not limited thereto.

The first nozzle 140 is connected to one region of the lateral surface 132 of the body 130, thereby spraying the cleaning solution, e.g., deionized water into the transport duct 108 of the body 130.

Openings 101 and 102 are provided in one region of the lateral surface 132 of the body 130. The first nozzle 140 may be connected to the openings 101 and 102. Thereby, the first nozzle 140 may spray the cleaning solution into the transport duct 108 of the body 130 through the openings 101 and 102.

At least one first nozzle 140 and at least one opening 101, 102 may be provided. FIGs. 2 and 3 show an embodiment provided with two first nozzles 140 and two openings 101 and 102. However, embodiments are not limited thereto. A plurality of first nozzles 142 and 144 may be arranged spaced apart from each other.

For example, the nozzle 142 may be spaced 180 apart from the nozzle 144.

The nozzle 142 may be connected to a first opening 101. Thereby, the nozzle 142 may spray the cleaning solution into the transport duct 108 of the body 130 through the first opening 101. The nozzle 144 may be connected to a second opening 102. Thereby, the nozzle 144 may spray the cleaning solution into the transport duct 108 of the body 130 through the second opening 102.

The blocking sheet 160 may be disposed in the transport duct 108 of the body 130 such that one end 162 thereof is positioned at the upper side of the first nozzle 140, and the other end 164 thereof is positioned at the lower side of the first nozzle 140.

For example, one end of the blocking sheet 160 may be the upper end of the blocking sheet 160, and the other end of the blocking sheet 160 may be the lower end of the blocking sheet 160. The blocking sheet 160 may be disposed in the transport duct 108 to be spaced apart from an inner wall 192 of the transport duct 108 of the body 130.

The first nozzle 140 may be disposed between one end 162 of the blocking sheet 160 and the other end thereof, and may spray the cleaning solution toward the lateral surface 166 of the blocking sheet 160.

The body 130 may include a fixing portion 134 positioned, at the upper side of the first nozzle 140, in the transport duct 108 to support and fix the one end 162 of the blocking sheet 160.

For example, the fixing portion 134 may be one region of the body 130 positioned at the upper side of the first nozzle 140. The inner diameter D1 of the fixing portion 134 may be smaller than the inner diameter D2 of the other portion of the body 130. The blocking sheet 160 may be fixed by the fixing portion 134, and thus may be prevented from being separated downward from the transport duct 108 of the body 130.

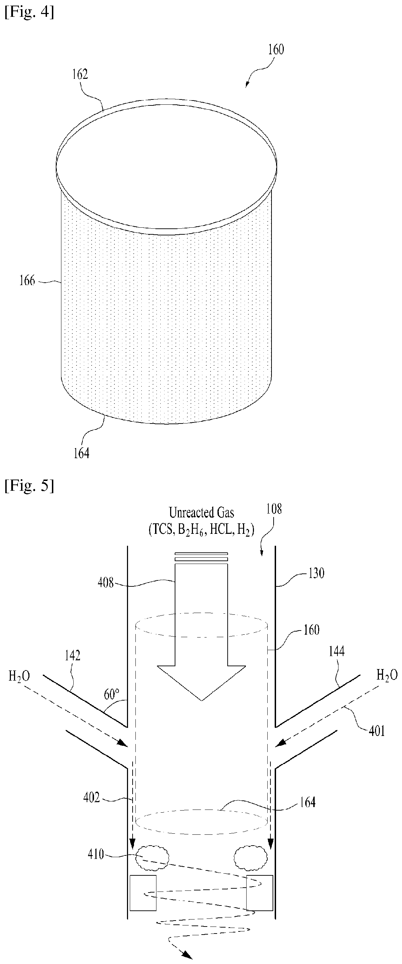

FIG. 4 illustrates the blocking sheet 160 shown in FIG. 3.

Referring to FIG. 4, the shape of the blocking sheet 160 may be determined according to the shape of the transport duct 108 of the body 130.

The blocking sheet 160 shown in FIG. 3 includes an upper end 162, a lower end 164, and a lateral surface 166 positioned between the upper end 162 and the lower end 164. The blocking sheet 160 is cylindrically formed and is open at the upper end 162 and the lower end 164. However, embodiments are not limited thereto.

The one end 162 of the blocking sheet 160 may be formed in a ring shape having a larger diameter than the lateral surface 166 to be held by the fixing portion 134. For example, the one end 162 of the blocking sheet 160 may be formed to protrude from the lateral surface 166.

The blocking sheet 160 may be formed of a resin material having a coefficient of friction less than that of the body 130, for example, polytetrafluoroethylene. However, embodiments are not limited thereto.

FIG. 5 is a conceptual view illustrating the function of the blocking sheet 160 shown in FIG. 3.

Referring to FIG. 5, at least one portion of the lateral surface 166 of the blocking sheet 160 may be adjacent to the openings 101 and 102.

The blocking sheet 160 blocks the cleaning solution sprayed from the first nozzles 142 and 144 from being introduced into one region P of the transport duct 108 positioned inside the blocking sheet 160. Thereby, the fluids positioned inside the blocking sheet 160, for example, unreacted gases 408 may be prevented from directly contacting and reacting with the cleaning solution.

For example, the cleaning solution 401 sprayed from the first nozzles 142 and 144 may be blocked from being supplied to the interior of the blocking sheet 160, by the outer wall of the blocking sheet 160 that the cleaning solution 401 hit. In addition, the cleaning solution 402 hitting the blocking sheet 160 may move down the lower portions of the first nozzles 142 and 144 along the inner wall 192 of the transport duct 108 or the outer wall of the blocking sheet 160.

Reaction between the cleaning solution sprayed from the first nozzles 142 and 144 and the unreacted gases 408 introduced into the transport duct 108 is prevented from occurring at an inner portion of the transport duct 108 adjacent to the first nozzles 142 and 144, by the blocking sheet 160. Thereby, a reaction product is not produced. In addition, the cleaning solution 402 moving down the blocking sheet 160 may react with the unreacted gases in a portion of the transport duct 108 under the lower end 164 of blocking sheet 160, producing a reaction product 410.

To allow the cleaning solution sprayed into the transport duct 108 to smoothly flow down along the transport duct 108, the first nozzles 142 and 144 may be inclined at a certain angle.

The angle that the first nozzles 142 and 144 make with a portion of the outer wall of the body 130 positioned at the upper side of the first nozzles 142 and 144 may be between 50° and 70°.

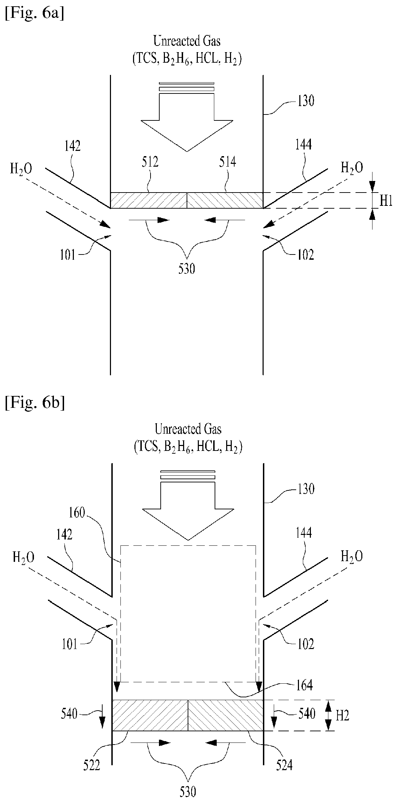

FIG. 6A illustrates formation of a reaction product in the case that the blocking sheet is not provided, and FIG. 6B illustrates formation of a reaction product in the cast that the blocking sheet 160 is provided.

Referring to FIG. 6A, the blocking sheet is not present, and accordingly reaction between the cleaning solution and the unreacted gases may actively take place at the inside of the transport duct 108 adjacent to the openings 101 and 102 of the first nozzles 142 and 144 from which the cleaning solution is sprayed. Thereby, reaction products 512 and 514 may be deposited on the inner wall of the transport duct 108 positioned at the upper side of the openings 101 and 102.

According to Formula 1, powdered SiO2 having high adhesiveness and high flammability may be produced as the reaction products 512 and 514.
ChemistryFigure 1

[Chem.1] *TCS*(*HSiCl*₃)+*H*₂*O*⇒*SiO*₂+*H*₂+3*Cl⁻*

The reaction products 512 and 514 may grow on the inner wall 192 of the transport duct 108 positioned at the upper side of the first nozzles 142 and 144 and functioning as a growth interface. Due to the cleaning solution sprayed from the first nozzles 142 and 144, the growth of the reaction product in a longitudinal direction may be limited. Accordingly, the growth of the reaction products 512 and 514 mainly occurs in a lateral direction 530. As the reaction product keeps growing in the lateral direction 530, the inner space of the transport duct 108 may be gradually narrowed, and ultimately the inlet may be clogged.

If the inlet is clogged, the amount of gases used in the reacting system 100 may increase, and the temperature may drastically drop. In addition, the pressure in the reacting system 100 may increase.

Referring to FIG. 6B, due to the blocking sheet 160, reaction between the cleaning solution and unreacted gases may not take place at the inside of the transport duct 108 adjacent to the openings 101 and 102 of the first nozzles 142 and 144, and reaction products 522 and 524 may be produced under the lower end 164 of the blocking sheet 160.

That is, the location at which the reaction products are produced may be shifted from a position around the first nozzles 142 and 144 to the lower end of the blocking sheet 160 or the inner wall of the transport duct 108 positioned under the blocking sheet 160 due to the blocking sheet 160.

The reaction products 522 and 524 may grow on the growth interface. In this case, the inner wall 192 of the transport duct 108 positioned under the blocking sheet 160, or the lower end 164 of the blocking sheet 160 is the growth interface.

Since the surface of the blocking sheet 160 formed of polytetrafluoroethylene is slipperier than the inner wall 192 of the transport duct 108 formed of PVC the blocking sheet 160, growth of the reaction products on the lateral surface of the blocking sheet 160 taken as the growth interface may be suppressed.

Since the lower end 164 of the blocking sheet 160 is positioned under the first nozzles 142 and 144, growth of the reaction products 522 and 524 in the longitudinal direction is not suppressed. Accordingly, the reaction products 522 and 524 may uniformly grow in the lateral direction 530 and the longitudinal direction 540.

The thickness H2 of the reaction products 522 and 524 shown in FIG. 6B may be greater than the thickness HI of the reaction products 512 and 514 shown in FIG. 6A. Thereby, the time taken for the inlet 20 shown in FIG. 6B to be clogged by the reaction products 522 and 524 may be longer than the time taken for the inlet 20 shown in FIG. 6A to be clogged by the reaction products 512 and 514.

In this embodiment, by providing the blocking sheet 160, the replacement period of the inlet clogged by the reaction products may be extended, and the time taken for the reacting system to be stopped for replacement of the inlet may be reduced. Thereby, the amount of production may increase.

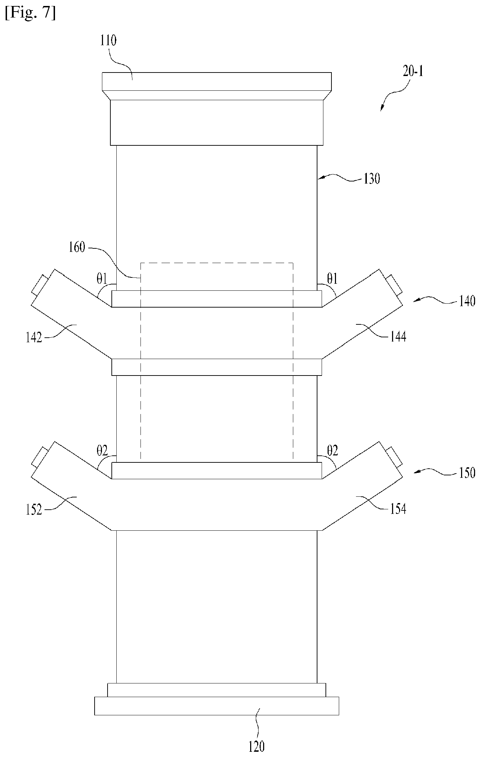

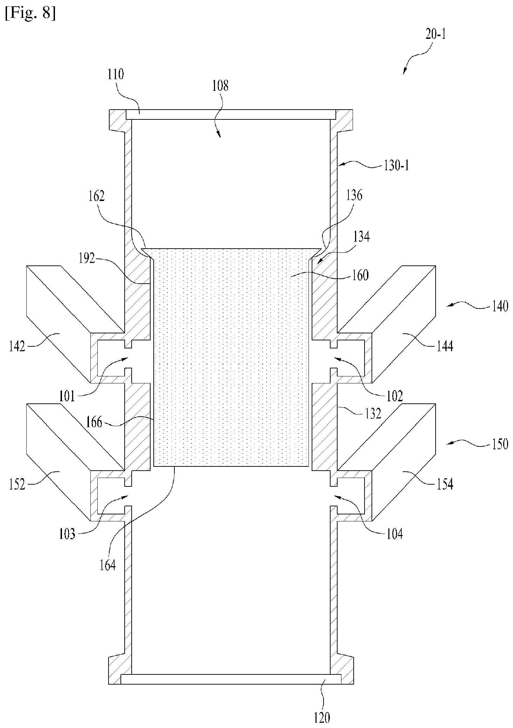

FIG. 7 is a front view illustrating an inlet 20-1 according to a second embodiment, and FIG. 8 is a cross-sectional view illustrating the inlet 20-1 shown in FIG. 7. The same reference numbers as used in FIGs. 2 and 3 represent the same constituents, a description of which will be omitted.

Compared to the inlet 20 shown in FIGs. 2 and 3, the inlet 20-1 shown in FIGs. 7 and 8 further includes a second nozzle 150.

The second nozzle 150 is connected to another region of the lateral surface 132 of the body 130 positioned under the lower end 164 of the blocking sheet 160. The second nozzle 150 may spray an inner gas such as, for example, Ar, Ne, He, N₂ and CO₂ into the transport duct 108.

At least one second nozzle 150 may be provided. FIG. 7 and FIG. 8 illustrate an embodiment provided with two second nozzles 150. However, embodiments are not limited thereto. A plurality of second nozzles 152 and 154 may be arranged spaced apart from each other.

For example, in the case that two second nozzles 150 are provided, the nozzle 152 may be spaced 180° apart from the nozzle 154.

The openings 103 and 104 may be provided in another region of the lateral surface 132 of the body 130-1 positioned under the first opening 101 and the second opening 102. The second nozzle 150 may be connected to the openings 103 and 104. Thereby, the second nozzle 150 may spray an inert gas toward the inner wall 192 of the transport duct 108 through the openings 103 and 104.

For example, the second nozzle 152 may be connected to the third opening 103. Thereby, the second nozzle 152 may spray an inert gas toward the inner wall 192 of the transport duct 108 through the third opening 103. In addition, the second nozzle 154 may be connected to a fourth opening 104. Thereby, the second nozzle 154 may spray an inert gas toward the inner wall 192 of the transport duct 108 through the fourth opening 104.

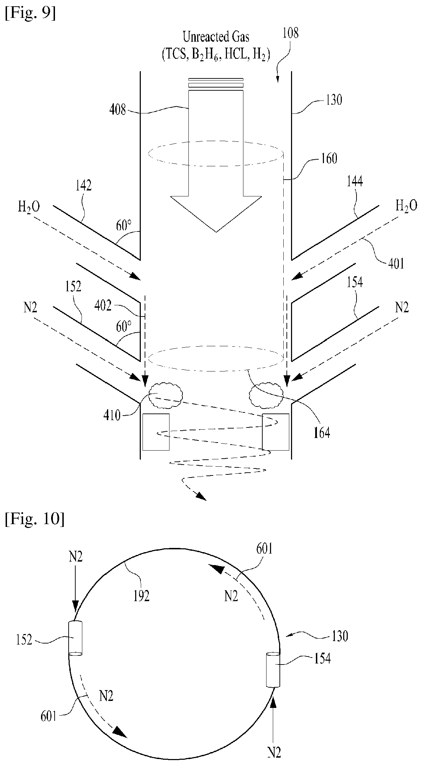

FIG. 9 is a conceptual view illustrating the function of the second nozzle 150 shown in FIG. 8.

Referring to FIG. 9, to suppress deposition of the reaction product 410 on the inner wall 192 of the transport duct 108 positioned under the blocking sheet 160, the second nozzles 152 and 154 may be inclined at a certain angle.

For example, the angle that the second nozzles 152 and 154 make with the outer wall of the body 130 positioned on the second nozzles 152 and 154 may be between 50°and 70°.

FIG. 10 is a view illustrating the spray direction of the second nozzle 150 shown in FIG. 8. Referring to FIG. 10, the second nozzle 150 does not spray an inert gas toward the center of the transport duct 108. Rather, the second nozzle 150 may spray the inert gas 601 along the inner wall 192 of the transport duct 108 positioned under the blocking sheet 160.

The second nozzles 152 and 154 may spray the inert gas 601 along the inner wall of the transport duct 108 in the same direction. For example, the second nozzles 152 and 154 may spray the inert gas 601 such that the inert gas 601 flows clockwise along the inner wall 192 of the transport duct 108.

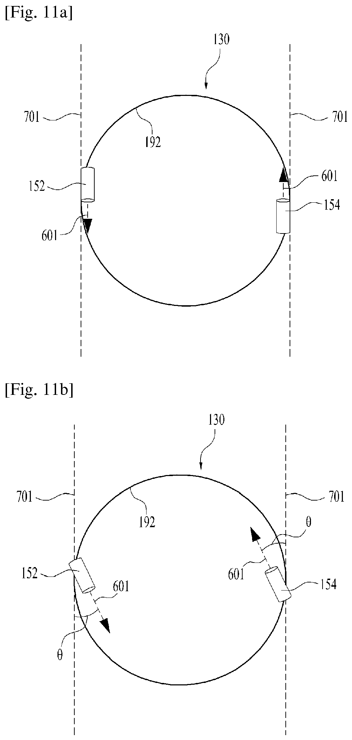

FIGs. 11A and 11B illustrate a spray direction of the second nozzles 152 and 154 according to one embodiment. Referring to FIG. 11A, the spay direction of the second nozzles 152 and 154 may be parallel with the normal line 701 to the inner wall 192 of the transport duct 108 adjacent to the second nozzle 150 and the openings 103 and 104.

Referring to FIG. 11B, the spray direction of the second nozzle 154 may make a certain angle (e.g., 0≤θ≤10° with the normal line 701 to the inner wall 192 of the transport duct 108 adjacent to the second nozzle 150 and the openings 103 and 104.

The inert gas 601 sprayed from the second nozzle 150 and flowing along the inner wall 192 of the transport duct 108 positioned under the blocking sheet 160 may suppress deposition of the reaction product 410 on the inner wall 192 of the transport duct 108.

As the second embodiment is provided with the second nozzle 150, deposition of the reaction product 410 on the inner wall 192 of the transport duct 108 may be suppressed. Accordingly, in the second embodiment, the replacement period of the inlet may be further extended, and the time for which the reacting system is stopped for replacement of the inlet may be further reduced, compared to the first embodiment. Thereby, the amount of production may further increase.

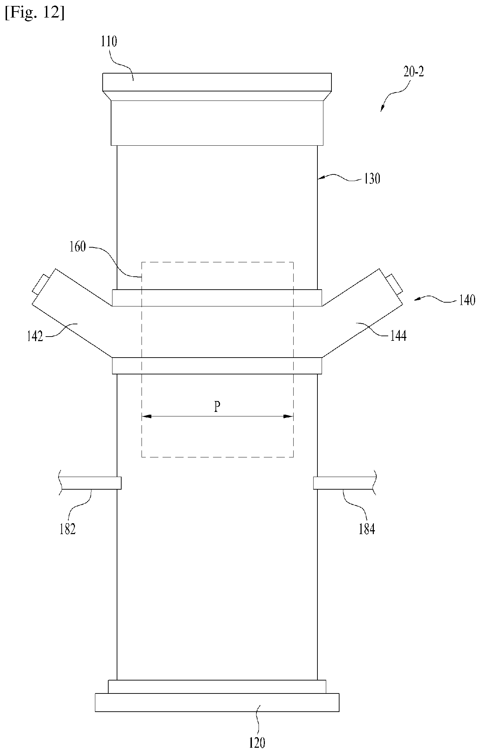

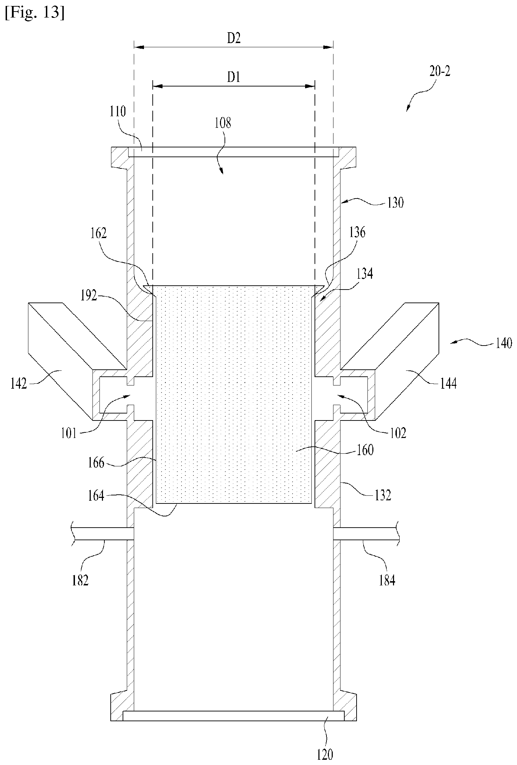

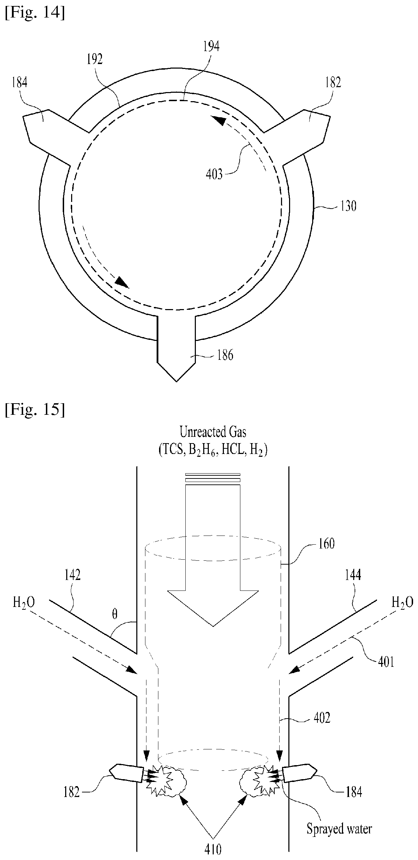

FIG. 12 is a front view illustrating an inlet 20-2 according to a third embodiment, and FIG. 13 is a cross-sectional view illustrating the inlet 20-2 shown in FIG. 12. FIG. 14 illustrates disposition of spray nozzles 182, 184 and 186 of the inlet 20-2 shown in FIG. 12. The same reference numbers as use in FIGs. 2 and 3 represent the same constituents, and accordingly a description thereof will be briefly given or omitted.

Referring to FIGs. 12 to 14, the inlet 20-2 may include an introduction portion 110, a discharge portion 120, a body 130, a first nozzle 140, a blocking sheet 160, and spray nozzles 182, 184 and 186.

The spray nozzles 182, 184 and 186 may be other regions of the lateral surface 132 of the body 130, and may spray a high-pressure liquid, for example, deionized water, or a gas, for example, air into a portion of the transport duct 108 positioned under the lower end 164 of the blocking sheet 160. Herein, the spray nozzles 182, 184 and 186 may be positioned under the lower end 164 of the blocking sheet 160.

The spray nozzles 182, 184 and 186 may spray a high-pressure liquid or gas onto reaction products deposited on the sidewall 192 of the transport duct 108 at the lower end 164 of the blocking sheet 160 to separate the reaction products from the sidewall 192 of the transport duct 108 or dissolve the reaction product.

In addition, the spray nozzles 182, 184 and 186 may spray a high-pressure liquid or gas onto reaction products deposited on the lower end 164 of the blocking sheet 160. The spray nozzles 182, 184 and 186 may spray a predetermined liquid or gas on the reaction products deposited on the lower end 164 of the blocking sheet 160 to separate the reaction products from the lower end 164 of the blocking sheet 160 or dissolve the reaction products. In this case, compared to the case shown in FIGs. 12 to 13, the spray nozzles 182, 184 and 186 may be positioned on the same level as the lower end 164 of the blocking sheet 160.

In addition, the spray nozzles 182, 184 and 186 may spray a high-pressure liquid or gas onto the lateral surface 166 of the blocking sheet 160. By spraying a high-pressure liquid or gas onto the lateral surface 166 of the blocking sheet 160, the spray nozzles 182, 184 and 186 may vibrate the blocking sheet 160. The reaction products deposited at the lower end 164 of the blocking sheet 160 may be separated from the blocking sheet 160 by vibration of the blocking sheet 160. In this case, compared to the case shown in FIGs. 12 and 13, the spray nozzles 182, 184 and 186 may be positioned on the lower end 164 of the blocking sheet 160.

The distance from the blocking sheet 160 to the spray nozzles 182, 184 and 186 may be between 2 mm and 5 mm. In the case that the distance from the blocking sheet 160 to the spray nozzles 182, 184 and 186 is less than 2 mm, water vapor may be produced and thereby reaction products may be easily deposited on the blocking sheet 160. In the case that the distance is greater than 5 mm, the spray pressure required for separation or dissolution of the reaction products may increase.

To separate the reaction products from the sidewall 192 of the transport duct 108 or the lower end 164 of the blocking sheet 160 and dissolve the reaction products, the spray pressure of the deionized water sprayed from the spray nozzles 182, 184 and 186 may be set to be higher than the spray pressure of the deionized water sprayed from the first nozzle 140.

For example, the ratio of the spray pressure of the deionized water sprayed from the first nozzle 140 to the spray pressure of the deionized water sprayed from the spray nozzles 182, 184 and 186 may be 1 : 1.5 - 3.

At least one spray nozzle 182, 184, 186 may be provided. A plurality of spray nozzles 182, 184 and 186 may be arranged spaced apart from each other.

In FIG. 14, three spray nozzles 182, 184 and 186 are spaced 120 apart from each other. However, embodiments are not limited thereto.

By the deionized water sprayed from the first nozzle 140, a water wall 194 rotating in a certain direction 403 along the inner wall 192 of the transport duct 108 may be formed. Each of the spray nozzles 182, 184 and 186 may not protrude from the inner wall 192 of the transport duct 108. This is intended to prevent one end of each of the spray nozzles 182, 184 and 186 from sticking out of the water wall 194. In the case that one end of each of the spray nozzles 182, 184 and 186 sticks out of the water wall 194, the end may act as a growth interface and thus the reaction product may be deposited thereon.

FIG. 15 is a conceptual view illustrating the function of the spray nozzles 182, 184 and 186 shown in FIG. 13.

Referring to FIG. 15, the spray nozzles 182, 184 and 186 may spray, at a predetermined pressure, a gas or a liquid (e.g, deionized water) onto the reaction product 410 deposited on the lower end of the blocking sheet 160 or on the inner wall of the transport duct 108 under the lower end of the blocking sheet 160, thereby separating the reaction product from the lower end of the blocking sheet 160 or the inner wall of the transport duct 108 or dissolving the reaction product.

Through such physical separation or breaking down of the reaction product, the inlet may be prevented from being clogged by the reaction product and may be semi-permanently used. In addition, the reacting system does not need to be stopped for replacement of the inlet, and accordingly the amount of production may increase.

Various embodiments have been described in the best mode for carrying out the invention.

### Industrial Applicability

According to one embodiment, a replacement period of an inlet may be extended, and the time for which the reacting system is stopped for replacement of the inlet may be reduced. Thereby, the amount of production may increase.

## Claims

1. An inlet comprising:
a body (130) provided therein with a transport duct (108) allowing a fluid to flow therethrough wherein a first opening (101) is provided in one region of a lateral surface (132) of the body;
at least one first nozzle (140, 142, 144) connected to the first opening (101, 102) and adapted to spray a cleaning solution into the transport duct (108) through the first opening (101,102);
a blocking sheet (160) disposed in the transport duct to be spaced apart from an inner wall (192) of the transport duct (108), wherein an upper end of the blocking sheet (160) is positioned at an upper side of the first opening (101), and a lower end of the blocking sheet (160) is positioned at a lower side of the first opening (101); and
at least one second nozzle (150, 182, 184)connected to another region of the lateral surface (132) of the body positioned under the lower end of the blocking sheet (160) and sprays a gas or a liquid into the transport duct (108),
wherein the cleaning solution sprayed from the first nozzle (142, 144) is blocked from being introduced into one region of the transport duct (108) positioned inside the blocking sheet (160),
wherein an outer wall of the blocking sheet (160) is spaced from the inner wall (192) of the transport duct (108).

2. The inlet according to claim 1, wherein a second opening (103, 104) is provided in another region of the lateral surface (132) of the body and connected to at least one second nozzle (150), and
wherein at least one seond nozzle sprays (150) the gas or the liquid into the transport duct (108) through the second opening (103, 104).

3. The inlet according to claim 1 or 2, wherein the body (130) is provided with a fixing portion (134) positioned at the upper side of the first nozzle (140, 142, 144) in the transport duct (108) to support an upper end of the blocking sheet (160).

4. The inlet according to claim 3, wherein the fixing portion (134) is a part of the body (130) positioned at the upper side of the first nozzle (140, 142, 144), wherein an inner diameter of the fixing portion (134)is less than an inner diameter of the other part of the body (130).

5. The inlet according to any one of claims 1 to 4, wherein at least one first nozzle (140, 142, 144) includes a plurality of first nozzles (142, 144) arranged spaced apart from each other.

6. The inlet according to claim 2, wherein an angle formed between the first nozzles (140, 142, 144) and an outer wall of the body (130) positioned at an upper side of the first nozzles (140, 142, 144) is between 50° and 70°, and
wherein the second opening (103, 104) is positioned under the first opening (101, 102) and the lower end of the blocking sheet (160).

7. The inlet according to any one of claims 1 to 6, wherein
the blocking sheet (160) is formed of a resin material having a coefficient of friction less than a coefficient of friction of the body (130).

8. The inlet according to claim 7, wherein the blocking sheet (160) is formed of polytetrafluoroethylene.

9. The inlet according to any one of claims 1 to 8, wherein the blocking sheet (160) is provided with an upper end, a lower end, and a lateral surface positioned between the upper end and the lower end, and is formed in a cylindrical shape and open at the upper end of the lower end.

10. The inlet according to claim 9, wherein the upper end of the blocking sheet (160) is formed in a ring shape having a diameter greater than a diameter of the lateral surface to be held by the fixing portion (134).

11. The inlet according to claim 10, wherein the upper end of the blocking sheet (160) protrudes from the lateral surface.

12. The inlet according to claim 2, wherein at least one second nozzle (150) sprays an inert gas.

13. The inlet according to any one of claims 1 to 12, wherein the at least one second nozzle (150, 182, 184) includes a plurality of second nozzles arranged spaced apart from each other.

14. The inlet according to any one of claims 1 to 13, wherein an angle formed between the second nozzles (150) and an outer wall of the body (130) positioned at an upper side of the second nozzles (150) is between 50° and 70°.

15. The inlet according to claim 13, wherein the second nozzles (150) spray an inert gas along an inner wall of the transport duct (108).

16. The inlet according to claim 15, wherein an angle formed between a direction in which the second nozzle (150) sprays the inert gas and a normal line to an inner wall of the transport duct (108) is greater than 0° and less than 10°.

17. The inlet according to any one of claims 1 to 16, at least one second nozzle (150, 182, 184) sprays at a predetermined spray pressure, the gas or the liquid onto a reaction product deposited on the lower end of the blocking sheet or deposited on the inner wall of the transport duct under the blocking sheet (160), wherein the reaction product is an output according to reaction between the fluid introduced into the transport duct (108) and the cleaning solution.

18. The inlet according to claim 17, wherein the least one first nozzle (140, 142, 144) and the at least one second nozzle (150, 182, 184) spray deionized water, the at least one second nozzle (150, 182, 184) including a plurality of spray nozzles(150, 182, 184).

19. The inlet according to claim 18, wherein a ratio of a spray pressure of the deionized water sprayed from the first nozzle (140, 142, 144) to a spray pressure of the deionized water sprayed from the plurality of spray nozzles (150, 182, 184) is 1 : 1.5 to 3.

20. A reacting system comprising:
a gas introduction pipe (5) to supply a source gas;
a reactor (10) to form a reaction product using the source gas supplied through the gas introduction pipe (5);
a gas discharge pipe (15) to discharge a gas produced after formation of the reaction product from the reactor (10);
a scrubber (30) to clean the gas discharged from the gas discharge pipe (15) using a cleaning solution; and
an inlet (20) according to any one of claims 1 to 19 to connect the gas discharge pipe (5) to the scrubber (30).

## Patentansprüche

1. Einlass, umfassend:
einen Körper (130), der mit einem Transportkanal (108) versehen ist, durch den ein Fluid strömen kann, wobei eine erste Öffnung (101) in einem Bereich einer Seitenfläche (132) des Körpers vorgesehen ist;
mindestens eine erste Düse (140, 142, 144), die mit der ersten Öffnung (101, 102) verbunden und geeignet ist, eine Reinigungslösung durch die erste Öffnung (101, 102) in den Transportkanal (108) zu sprühen;
eine Sperrlage (160), die in dem Transportkanal angeordnet ist, um von einer Innenwand (192) des Transportkanals (108) beabstandet zu sein, wobei ein oberes Ende der Sperrlage (160) an einer Oberseite der ersten Öffnung (101) und ein unteres Ende der Sperrlage (160) an einer Unterseite der ersten Öffnung (101) angeordnet ist; und
mindestens eine zweite Düse (150, 182, 184), die mit einem anderen Bereich der Seitenfläche (132) des Körpers verbunden ist, der unter dem unteren Ende der Sperrlage (160) angeordnet ist und ein Gas oder eine Flüssigkeit in den Förderkanal (108) spritzt,
wobei die von der ersten Düse (142, 144) gespritzte Reinigungslösung daran gehindert wird, in einen Bereich des Transportkanals (108) eingeführt zu werden, der innerhalb der Sperrlage (160) angeordnet ist,
wobei eine Außenwand der Sperrlage (160) von der Innenwand (192) des Transportkanals (108) beabstandet ist.

2. Einlass nach Anspruch 1, wobei eine zweite Öffnung (103, 104) in einem anderen Bereich der Seitenfläche (132) des Körpers vorgesehen und mit mindestens einer zweiten Düse (150) verbunden ist, und
wobei mindestens eine zweite Düse das Gas oder die Flüssigkeit durch die zweite Öffnung (103, 104) in den Transportkanal (108) spritzt (150).

3. Einlass nach Anspruch 1 oder 2, wobei der Körper (130) mit einem Befestigungsabschnitt (134) versehen ist, der an der Oberseite der ersten Düse (140, 142, 144) im Transportkanal (108) angeordnet ist, um ein oberes Ende der Sperrlage (160) zu tragen.

4. Einlass nach Anspruch 3, wobei der Befestigungsabschnitt (134) ein Teil des Körpers (130) ist, der an der Oberseite der ersten Düse (140, 142, 144) angeordnet ist,
wobei ein Innendurchmesser des Befestigungsabschnitts (134) kleiner ist als ein Innendurchmesser des anderen Teils des Körpers (130).

5. Einlass nach einem der Ansprüche 1 bis 4, wobei mindestens eine erste Düse (140, 142, 144) eine Mehrzahl von ersten Düsen (142, 144) enthält, die beabstandet voneinander angeordnet sind.

6. Einlass nach Anspruch 2, wobei ein Winkel, der zwischen den ersten Düsen (140, 142, 144) und einer Außenwand des Körpers (130) gebildet ist, der an einer Oberseite der ersten Düsen (140, 142, 144) angeordnet ist, zwischen 50° und 70° liegt, und
wobei die zweite Öffnung (103, 104) unter der ersten Öffnung (101, 102) und dem unteren Ende des Sperrblechs (160) positioniert ist.

7. Einlass nach einem der Ansprüche 1 bis 6, worin
die Sperrlage (160) aus einem Harzmaterial mit einem Reibungskoeffizienten von weniger als einem Reibungskoeffizienten des Körpers (130) gebildet ist.

8. Einlass nach Anspruch 7, wobei die Sperrlage (160) aus Polytetrafluorethylen gebildet ist.

9. Einlass nach einem der Ansprüche 1 bis 8, wobei die Sperrlage (160) mit einem oberen Ende, einem unteren Ende und einer zwischen dem oberen Ende und dem unteren Ende angeordneten Seitenfläche versehen ist und in einer zylindrischen Form ausgebildet und am oberen Ende des unteren Endes offen ist.

10. Einlass nach Anspruch 9, wobei das obere Ende der Sperrlage (160) in einer Ringform mit einem Durchmesser größer als ein Durchmesser der Seitenfläche ausgebildet ist, die durch den Befestigungsabschnitt (134) gehalten werden soll.

11. Einlass nach Anspruch 10, wobei das obere Ende der Sperrlage (160) aus der Seitenfläche herausragt.

12. Einlass nach Anspruch 2, wobei mindestens eine zweite Düse (150) ein Schutzgas versprüht.

13. Einlass nach einem der Ansprüche 1 bis 12, wobei die mindestens eine zweite Düse (150, 182, 184) eine Mehrzahl von zweiten Düsen beinhaltet, die beabstandet voneinander angeordnet sind.

14. Einlass nach einem der Ansprüche 1 bis 13, wobei ein zwischen den zweiten Düsen (150) und einer Außenwand des Körpers (130) gebildeter Winkel, der an einer Oberseite der zweiten Düsen (150) angeordnet ist, zwischen 50° und 70° liegt.

15. Einlass nach Anspruch 13, wobei die zweiten Düsen (150) ein Schutzgas entlang einer Innenwand des Transportkanals (108) versprühen.

16. Einlass nach Anspruch 15, wobei ein Winkel, der zwischen einer Richtung, in der die zweite Düse (150) das Schutzgas versprüht, und einer normalen Leitung zu einer Innenwand des Transportkanals (108) gebildet wird, größer als 0° und kleiner als 10° ist.

17. Einlass nach einem der Ansprüche 1 bis 16, mindestens eine zweite Düse (150, 182, 184) spritzt mit einem vorbestimmten Spritzdruck, das Gas oder die Flüssigkeit auf ein Reaktionsprodukt, das am unteren Ende der Sperrlage (160) abgeschieden oder an der Innenwand des Transportkanals unter der Sperrlage (160) abgeschieden ist, wobei das Reaktionsprodukt eine Ausgabe gemäß der Reaktion zwischen dem in den Transportkanal (108) eingebrachten Fluid und der Reinigungslösung ist.

18. Einlass nach Anspruch 17, wobei die mindestens eine erste Düse (140, 142, 144) und die mindestens eine zweite Düse (150, 182, 184) deionisiertes Wasser sprühen, die mindestens eine zweite Düse (150, 182, 184) eine Mehrzahl von Sprühdüsen (150, 182, 184) aufweist.

19. Einlass nach Anspruch 18, wobei ein Verhältnis eines Spritzdrucks des von der ersten Düse (140, 142, 144) gesprühten deionisierten Wassers zu einem Spritzdruck des von der Mehrzahl von Spritzdüsen (150, 182, 184) gesprühten deionisierten Wassers 1 : 1,5 bis 3 beträgt.

20. Reaktionssystem, umfassend:
ein Gaseinführungsrohr (5) zum Zuführen eines Quellgases;
einen Reaktor (10), um ein Reaktionsprodukt unter Verwendung des durch das Gaseinführungsrohr (5) zugeführten Quellgases zu bilden;
eine Gasentladungsleitung (15), um ein nach der Bildung des Reaktionsprodukts aus dem Reaktor (10) erzeugtes Gas abzuführen;
einen Wäscher (30) zum Reinigen des aus der Gasentladungsleitung (15) abgeleiteten Gases unter Verwendung einer Reinigungslösung; und
einen Einlass (20) nach einem der Ansprüche 1 bis 19, um die Gasabführleitung (5) mit dem Wäscher (30) zu verbinden.

## Revendications

1. Entrée comprenant :
un corps (130) pourvu à l'intérieur d'un conduit de transport (108) permettant à un fluide de s'écouler à travers celui-ci dans lequel une première ouverture (101) est pourvue dans une région d'une surface latérale (132) du corps ;
au moins une première buse (140, 142, 144) connectée à la première ouverture (101, 102) et adaptée pour pulvériser une solution de nettoyage dans le conduit de transport (108) à travers la première ouverture (101, 102) ;
une feuille de blocage (160) disposée dans le conduit de transport pour être espacée d'une paroi interne (192) du conduit de transport (108), dans laquelle une extrémité supérieure de la feuille de blocage (160) est positionnée au niveau d'un côté supérieur de la première ouverture (101), et une extrémité inférieure de la feuille de blocage (160) est positionnée au niveau d'un côté inférieur de la première ouverture (101) ; et
au moins une deuxième buse (150, 182, 184) connectée à une autre région de la surface latérale (132) du corps positionnée sous l'extrémité inférieure de la feuille de blocage (160) et pulvérise un gaz ou un liquide dans le conduit de transport (108),
dans laquelle la solution de nettoyage pulvérisée à partir de la première buse (142, 144) est bloquée et ne peut pas être introduite dans une région du conduit de transport (108) positionnée à l'intérieur de la feuille de blocage (160),
dans laquelle une paroi externe de la feuille de blocage (160) est espacée de la paroi interne (192) du conduit de transport (108).

2. Entrée selon la revendication 1, dans laquelle une deuxième ouverture (103, 104) est pourvue dans une autre région de la surface latérale (132) du corps et connectée à au moins une deuxième buse (150), et
dans laquelle au moins une deuxième buse (150) pulvérise le gaz ou le liquide dans le conduit de transport (108) à travers la deuxième ouverture (103, 104).

3. Entrée selon la revendication 1 ou 2, dans laquelle le corps (130) est pourvu d'une partie de fixation (134) positionnée au niveau du côté supérieur de la première buse (140, 142, 144) dans le conduit de transport (108) pour supporter une extrémité supérieure de la feuille de blocage (160).

4. Entrée selon la revendication 3, dans laquelle la partie de fixation (134) est une partie du corps (130) positionnée au niveau du côté supérieur de la première buse (140, 142, 144),
dans laquelle un diamètre interne de la partie de fixation (134) est inférieur à un diamètre interne de l'autre partie du corps (130).

5. Entrée selon l'une quelconque des revendications 1 à 4, dans laquelle au moins une première buse (140, 142, 144) comprend une pluralité de premières buses (140, 142, 144) agencées de manière espacée les unes des autres.

6. Entrée selon la revendication 2, dans laquelle un angle formé entre les premières buses (140, 142, 144) et une paroi externe du corps (130) positionnée au niveau d'un côté supérieur des premières buses (140, 142, 144) est entre 50° et 70°, et
dans laquelle la deuxième ouverture (103, 104) est positionnée sous la première ouverture (101, 102) et l'extrémité inférieure de la feuille de blocage (160).

7. Entrée selon l'une quelconque des revendications 1 à 6, dans laquelle
la feuille de blocage (160) est formée d'un matériau de résine ayant un coefficient de frottement inférieur à un coefficient de frottement du corps (130).

8. Entrée selon la revendication 7, dans laquelle la feuille de blocage (160) est formée de polytétrafluoroéthylène.

9. Entrée selon l'une quelconque des revendications 1 à 8, dans laquelle la feuille de blocage (160) est pourvue d'une extrémité supérieure, d'une extrémité inférieure, et d'une surface latérale positionnée entre l'extrémité supérieure et l'extrémité inférieure, et est formée sous une forme cylindrique et ouverte au niveau de l'extrémité supérieure de l'extrémité inférieure.

10. Entrée selon la revendication 9, dans laquelle l'extrémité supérieure de la feuille de blocage (160) est formée sous une forme d'anneau ayant un diamètre supérieur à un diamètre de la surface latérale devant être maintenue par la partie de fixation (134).

11. Entrée selon la revendication 10, dans laquelle l'extrémité supérieure de la feuille de blocage (160) fait saillie à partir de la surface latérale.

12. Entrée selon la revendication 2, dans laquelle au moins une deuxième buse (150) pulvérise un gaz inerte.

13. Entrée selon l'une quelconque des revendications 1 à 12, dans laquelle l'au moins une deuxième buse (150, 182, 184) comprend une pluralité de deuxièmes buses agencées de manière espacée les unes des autres.

14. Entrée selon l'une quelconque des revendications 1 à 13, dans laquelle un angle formé entre les deuxièmes buses (150) et une paroi externe du corps (130) positionnée au niveau d'un côté supérieur des deuxièmes buses (150) est entre 50° et 70°.

15. Entrée selon la revendication 13, dans laquelle les deuxièmes buses (150) pulvérisent un gaz inerte le long d'une paroi interne du conduit de transport (108).

16. Entrée selon la revendication 15, dans laquelle un angle formé entre une direction dans laquelle la deuxième buse (150) pulvérise le gaz inerte et une ligne normale vers une paroi interne du conduit de transport (108) est supérieur à 0° et inférieur à 10°.

17. Entrée selon l'une quelconque des revendications 1 à 16, au moins une deuxième buse (150, 182, 184) pulvérise à une pression de pulvérisation prédéterminée, le gaz ou le liquide sur un produit de réaction déposé sur l'extrémité inférieure de la feuille de blocage ou déposé sur la paroi interne du conduit de transport sous la feuille de blocage (160), dans laquelle le produit de réaction est une sortie selon une réaction entre le fluide introduit dans le conduit de transport (108) et la solution de nettoyage.

18. Entrée selon la revendication 17, dans laquelle l'au moins une première buse (140, 142, 144) et l'au moins une deuxième buse (150, 182, 184) pulvérisent de l'eau déionisée, l'au moins une deuxième buse (150, 182, 184) comprenant une pluralité de buses de pulvérisation (150, 182, 184).

19. Entrée selon la revendication 18, dans laquelle un rapport entre une pression de pulvérisation de l'eau déionisée pulvérisée à partir de la première buse (140, 142, 144) et une pression de pulvérisation de l'eau déionisée pulvérisée à partir de la pluralité de buses de pulvérisation (150, 182, 184) est de 1 : 1,5 à 3.

20. Système de réaction comprenant :
un tuyau d'introduction de gaz (5) pour fournir un gaz source ;
un réacteur (10) pour former un produit de réaction en utilisant le gaz source fourni par l'intermédiaire du tuyau d'introduction de gaz (5) ;
un tuyau d'évacuation de gaz (15) pour évacuer un gaz produit après la formation du produit de réaction à partir du réacteur (10) ;
un laveur (30) pour nettoyer le gaz évacué à partir du tuyau d'évacuation de gaz (15) en utilisant une solution de nettoyage ; et
une entrée (20) selon l'une quelconque des revendications 1 à 19 pour connecter le tuyau d'évacuation de gaz (5) au laveur (30).
